# EUROPEAN PATENT SPECIFICATION

(11) **EP 2 371 992 B1**
(45) Date of publication and mention of the grant of the patent: **05.06.2013**
(21) Application number: 10159023.0
(22) Date of filing: 01.04.2010
(51) Int. Cl.: C23C 14/34, H01J 37/34, F16C 19/00

(54) **End-block and sputtering installation**
Endblock und Zerstäubungsvorrichtung
Bloc terminal et installation de pulvérisation

(43) Date of publication of application: 05.10.2011
(73) Proprietor: Applied Materials, Inc., Santa Clara, CA 95054 (US)
(72) Inventor: Schnappenberger, Frank, 55218 Ingelheim (DE)
(74) Representative: Zimmermann & Partner

(56) References cited:
- US-A- 5 200 049
- US-A1- 2006 157 346
- US-A1- 2007 039 187
- US-A1- 2008 105 543
- US-A1- 2008 202 925
- US-A1- 2009 258 739

## Description

### FIELD OF THE INVENTION

The present disclosure relates to an end-block for carrying a rotatable target, particularly to an end-block including a bearing. Further, the present disclosure relates to a sputtering installation including an end-block.

### BACKGROUND OF THE INVENTION

In many applications it is desired to deposit thin layers on a substrate. Known techniques for depositing thin layers are in particular evaporating, chemical vapor sputtering and sputtering deposition. For example, sputtering can be used to deposit a thin layer such as a thin layer of a metal, e.g. aluminum, or ceramics. During the sputtering process, the coating material is transported from a sputtering target consisting of that material to the substrate to be coated by bombarding the surface of the target with ions of a typically inert processing gas at low pressure. The ions are produced by electron impact ionization of the processing gas and accelerated by a high voltage drop between the target operating as a sputtering cathode and an anode. This bombardment of the target results in the ejection of atoms or molecules of the coating material, which accumulate as a deposited film on the substrate arranged opposite to the sputtering cathode, e.g. below the sputtering cathode.

Segmented planar, monolithic planar and rotatable targets may be used for sputtering. Due to the geometry and design of the cathodes, rotatable targets typically have a higher utilization and an increased operation time than planar ones. Accordingly, the use of rotatable targets typically prolongs service lives and reduces costs.

The rotary cathode is typically supported by a cathode drive unit of the sputtering installation. In the following the cathode drive unit is also referred to as an end-block and a cathode drive-block, respectively. During sputtering, the cathode drive unit rotatably transfers movement to the rotary cathode. Given longitudinal extensions of rotary cathodes of up to about 4 m and typical continuous operation times of sputtering installations of several days, the bearing of the cathode drive unit is typically desired to reliably bear heavy mechanical loads over a long period of time.

Typical functionalities of end-blocks are outlined in document US 2008/0128276 A1. Further, document US 2006/0157346 A1 describes rotatable target assemblies, in particular for small sized installations, with a gas-to-vacuum seal and a gas-to-coolant seal inside the target tube. The bearing system for rotatably supporting the target tube may be arranged inside or outside the target tube.

Sputtering is typically carried out under low pressure or vacuum condition, i.e. in a vacuum chamber. For cost reasons, cathode drive units, in particular when arranged within a vacuum chamber of a sputtering installation, are typically also desired to have low space requirements. Realizing a reliable and less space bearing of the rotatable target is, however, a demanding task. Accordingly, there is an ongoing need for improved cathode drive units, in particular compact cathode drive units.

Embodiments of the invention provide an end-block for a rotatable target and a deposition apparatus as set forth in independent claims 1 and 14, respectively.

### BRIEF DESCRIPTION

So that the manner in which the above recited features of the present invention can be understood in detail, a more particular description of the invention, briefly summarized above, may be had by reference to embodiments. The accompanying drawings relate to embodiments of the invention and are described in the following:

According to an embodiment, an end-block for carrying a rotatable target of a deposition apparatus is provided. The end-block includes a base body which is adapted to be rigidly connected to a non-revolving part of the deposition apparatus. The end-block further includes at least one rotary bearing which is arranged around the base body and defines a rotational axis, and a rotor which is arranged around the base-body and adapted to receive the rotatable target.

According to an embodiment, a deposition apparatus, which has a process chamber with a non-revolving part and at least one end-block mounted thereto, is provided. The end-block includes a base body, at least one rotary bearing arranged around the base body and a rotor arranged around the at least one rotary bearing. The base body is fixed to a non-revolving part of the deposition apparatus and the rotor is adapted to receive a rotatable target.

According to an embodiment, a cathode drive-block of a sputtering installation for supporting a rotatable target is provided. The drive-block includes a base body which is adapted to be rigidly coupled to a non-revolving part of the sputtering installation. Further, the drive-block includes a rotor which is rotatably mounted around the base body and adapted to receive the rotatable target.

Further aspects, advantages and features of the present invention are apparent from the dependent claims, the description and the accompanying drawings.

### BRIEF DESCRIPTION OF THE DRAWINGS

Some of the above mentioned embodiments will be described in more detail in the following description of typical embodiments with reference to the following drawings in which:

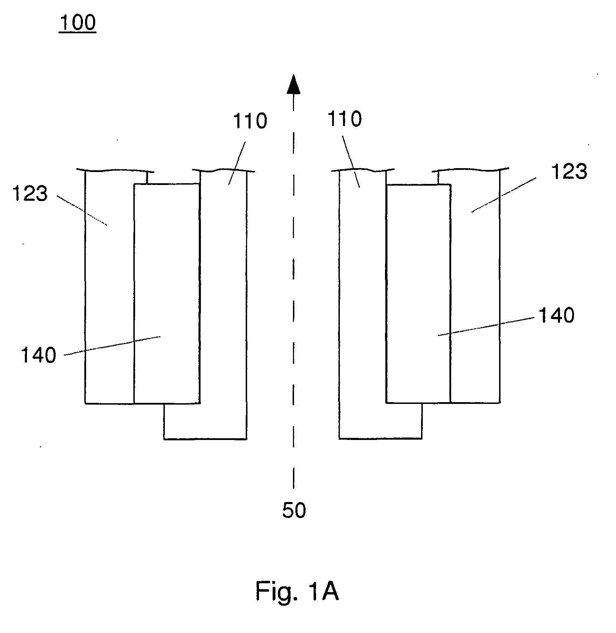

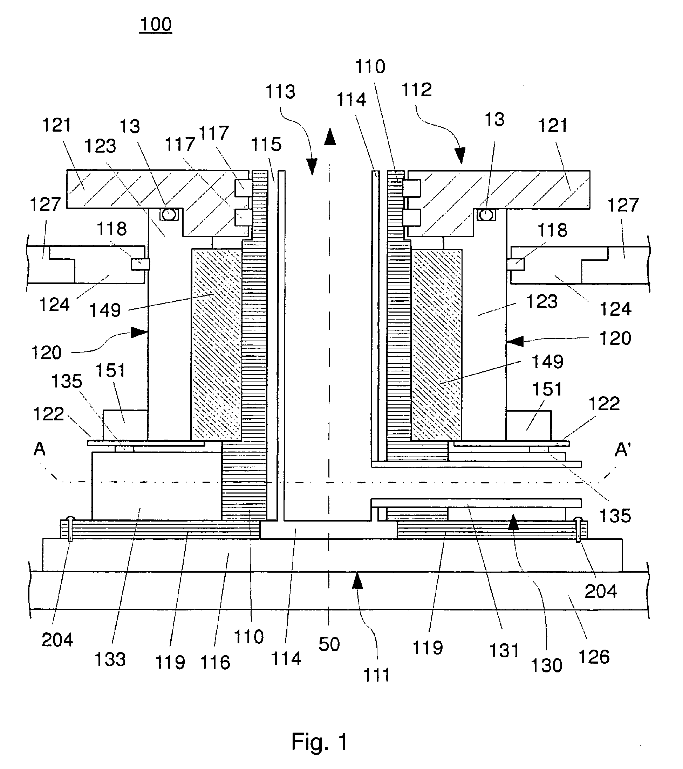

Fig. 1A shows schematically a cross section of an end-block along a rotational axis according to embodiments;

Fig. 1 shows schematically a cross section of an end-block along a rotational axis according to embodiments;

Fig. 2 shows schematically a cross section of a rotatable target mounted to a target flange of an end-block along a rotational axis according to embodiments;

Fig. 3 shows schematically a cross section of an end-block along the line A-A' of Fig. 1 according to embodiments;

Fig. 4 shows schematically a cross section of an end-block along a rotational axis according to embodiments;

Fig. 5 shows schematically a section of the cross section of Fig. 4 according to embodiments;

Fig. 6 shows schematically a cross section of a sputtering installation according to embodiments;

Fig. 7 shows schematically a cross section of a sputtering installation according to embodiments;

Fig. 8 shows schematically a cross section of a sputtering installation according to embodiments;

The elements of the drawing are not necessarily to scale relative to each other. Like reference numerals designate corresponding similar parts.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Sputtering is a process in which atoms are ejected from a solid target material due to bombardment of the target by energetic particles. The process of coating a substrate as a material at the scraping refers typically to thin film applications. The term "coating" and the term "depositing" are used synonymously herein. The terms "sputtering installation" and "deposition apparatus" are used synonymously herein and shell embrace an apparatus which uses sputtering for depositing a target material, typically as a thin film, on a substrate.

Typical target materials include but are not limited to pure metals such as aluminum (A1), copper (Cu), silver (Ag) and gold (Au), metal alloys such as such as an aluminum-niobium (AlNb) alloy or an aluminum-nickel (AlNi) alloy, semiconductor materials such as silicon (Si) and dielectric materials such as nitrides, carbides, titanates, silicates, aluminates and oxides, in particular nitrides, carbides, titanates, silicates, aluminates or oxides of the above-mentioned materials. For example, transparent conducting oxides (TCO) such as impurity-doped ZnO, e.g. ZnO:Al, AlZnO, In₂O₃, SnO₂ and CdO, as well as Sn doped In₂O₃ (ITO) and F doped SnO₂.

The term "substrate" as used herein shall embrace both inflexible substrates, e.g. a wafer or a glass plate, and flexible substrates such as webs and foils.

Representative examples include but are not limited to applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

With respect to Fig. 1A, embodiments pertaining to end-blocks are explained. The term "end-block" as used herein shall embrace a device which is adapted to be mounted to a non-revolving part, typically to a wall, flap or door, of a sputtering installation and which is adapted to transfer rotary movement to a rotatable target. The terms "end-block", "cathode drive-head" and the term "cathode drive-block" are used synonymously herein. The terms "end-block", "cathode drive-head" and "cathode drive-block" as used herein shall particularly embrace devices which in addition provide coolant and/or electrical current to the rotatable target while maintaining vacuum integrity and a closed coolant circuit.

Given longitudinal extensions of rotatable targets of up to about 1.5 m, up to about 2.5 m or even up to about 4 m and typical continuous operation times of sputtering installations of several days, the bearing of the end-block is typically desired to reliably bear heavy mechanical loads over a long period of time.

The term "rotatable target" as used herein shall embrace any cathode assembly which is adapted to be rotatably mounted to a sputtering installation and which includes a target structure adapted for being sputtered. The term "rotatable target" as used herein shall particularly embrace magnetically enhanced cathode assemblies which in addition include internal magnetic means, e.g. permanent magnets, for improved sputtering.

Rotatable targets, in the following also referred to as rotatable sputtering cathodes and rotary cathodes, respectively, may be made of a hollow cylindrical body of the target material. These rotary targets are also referred to as monolithic targets and may be manufactured by casting or sintering of the target material.

Non-monolithic rotatable targets typically include a cylindrical rotatable tube, e.g. a backing tube, having a layer of the target material applied to the outer surface thereof. In the manufacture of such rotatable sputtering cathodes, the target material may for example be applied by spraying onto, or casting or isostatic pressing of powder onto the outer surface of a backing tube. Alternatively, a hollow cylinder of a target material, which may also be referred to as a target tube, may be arranged on and bonded, e.g. with indium, to the backing tube for forming a rotary cathode. According to yet further alternatives, non-bonded target cylinders can be provided radially outward of a backing tube.

In order to obtain increased deposition rates, the use of magnetically enhanced cathodes has been proposed. This may also be referred to as magnetron sputtering. Magnetic means, which may include an array of magnets, may be arranged inside the sputtering cathode, e.g. inside a backing tube or inside a monolithic target, and provide a magnetic field for magnetically enhanced sputtering. The cathode is typically rotatable about its longitudinal axis so that it can be turned relative to the magnetic means.

In operation, un-cooled magnets may become hot. This is due to the fact that they are surrounded by target material that is bombarded with ions. The resulting collisions lead to a heating up of the rotary cathode. In order to keep the magnets at a suitable operating temperature, a cooling of the target material and the magnets may be provided.

Fig. 1A shows schematically an end-block 100 in a typical cross section along a rotational axis 50 around which a rotatable target (not shown) may rotate during sputtering. The rotational axis 50 also forms a longitudinal axis 50 of the end-block 100 and defines an axial direction. In this regard, directional terminology, such as "top," "bottom," "upper," "lower," "above," "below," "on," etc., is used with reference to the orientation of the rotational axis 50. The term "axial load" as used herein intends to describe a load and force, respectively, in direction to the rotational axis 50. Accordingly, the term "radial load" as used herein intends to describe a load and force, respectively, in a direction which is essentially orthogonal to the rotational axis 50. Likewise, the term "radial direction" as used herein intends to describe a direction which is essentially orthogonal to the rotational axis 50.

According to an embodiment, which may be combined with other embodiments disclosed herein, the end-block 100 includes a base body 110, a rotary bearing 140 which is arranged around the base body 110, and a bearing housing 123 which is arranged around and connected to the rotary bearing 140. The bearing housing 123 forms a part of a rotor carrying the rotatable target for sputtering. During sputtering, the base body 110 is rigidly connected to a non-revolving part of a deposition apparatus (not shown), typically to an external housing of the end-block 100 which is mounted to e.g. a wall of the deposition apparatus.

Arranging a rotor, which is adapted to mechanically support the rotational target, around a non-rotating base body 110 results in a compact and space reduced design of the end-block 100.

With respect to Fig. 1 several embodiments of an end-block 100 are explained. Fig. 1 shows schematically the end-block 100 in a typical cross section along a rotational axis 50 around which a rotatable target (not shown) may rotate during sputtering.

Typically, the end-block 100 includes an external housing. In the shown cross-section, only parts of a lower wall 126 and an upper wall 127 of the external housing are shown. During sputtering, the external housing does typically not rotate relative to the process chamber in which the sputtering is carried out. The process chamber is typically a low pressure chamber and in the following also referred to as vacuum chamber. The external housing may e.g. be attached to a wall of the process chamber. For stability reasons, the external housing is typically made of a metal, e.g. steel, stainless steel or aluminum.

According to embodiments, the end-block 100 has a base body 110, typically a hollow base body 110, which is rigidly connected to the lower wall 126 of the external housing. Therefore, the base body 110 does also not rotate relative to the process chamber during sputtering.

In other words, the base body 110 is typically rigidly connected to a non-revolving part of the deposition apparatus.

Typically, within the base body 110 a fluid support for the rotational target is provided. According to embodiments, a cylindrical cavity 113, which is coaxial to the rotational axis 50, is formed in the base body 110. Typically, a coolant tube 114 is coaxially inserted into the cylindrical cavity 113. In addition, a hollow cylindrical interspace 115 is typically formed between the coolant tube 114 and the inner walls of the base body 110. The coolant tube 114 and the interspace 115 may be used to support the rotational target with coolant, e.g. water. Typically, cold coolant flows upwards in the interspace 115 and warmed up coolant flows downwards in the coolant tube 114. The flow direction of the coolant may also be reversed.

According to embodiments, a bearing system 149 is arranged around the base body 110. The bearing system 149 is typically coaxial to the rotational axis, i.e. the bearing system 149 determines the rotational axis 50. According to embodiments, a rotor 120 is arranged around the bearing system 149. The rotor 120 is in an upper part outside the external housing adapted to receive the rotational target. Thereby, the rotational target may be rotated around the rotational axis. Typically, the rotor 120 provides mechanical support for the rotational target, i.e. the rotor 120 typically carries the rotational target and transfers rotational movement to the rotational target during sputtering. Arranging a rotor 120, which is adapted to mechanically support the rotational target, around a non-rotating base body 110 results in a compact and space reduced design of the end-block 100. Thereby, space within the process chamber and hence costs can be reduced.

According to embodiments, the bearing system 149 is adapted to carry both radial and axial loads resulting from the movement of the rotatable target during sputtering. Typically, the bearing system 149 includes at least one tapered roller bearing, e.g. one annular tapered roller bearing. Tapered roller bearings support both radial and axial loads, and typically can carry higher loads than e.g. ball bearings due to greater contact area.

According to embodiments, the rotor 120 includes a bearing housing 123 which is arranged around and connected to the bearing system 149. Typical cross-sections which are orthogonal to the rotational axis 50 and go through the bearing system 149 may show annular sections of the bearing housing 123, the coolant tube 114 and the base body 110.

According to embodiments, a gear-wheel 151 is arranged around and fastened to the bearing housing 123 to transfer rotational movement to the rotor 120. Typically, the gear-wheel 151 is fastened to a lower part, as shown in Fig. 1, or a middle part of the bearing housing 123. This facilitates mechanical coupling between the gear-wheel 151 and a rotating electric drive through the external housing, e.g. via a belt.

According to embodiments, a target flange 121 is arranged on and vacuum tightly mounted to the bearing housing 123. Typically, an O-ring seal 13 is arranged between the bearing housing 123 and the target flange 121. As the target flange 121 and the bearing housing 123 are typically non-rotatably coupled to each other, a rotatable target mounted on top of the target flange 121 may be rotated by the rotating electric drive.

During sputtering, at least an upper part or the target flange 121 is typically arranged outside the external housing, i.e. in a low pressure or vacuum environment. Different thereto, the internal space of the external housing is typically at normal and/or a higher pressure than the process chamber. To avoid an exchange of gas, a seal carrier 124 is, according to embodiments, vacuum-tightly arranged between the upper wall 127 of the external housing and the rotor 120. In a typical embodiment a sliding annular vacuum seal 118 is arranged between the seal carrier 124 and the bearing housing 123. The seal carrier 124 may also be attached to the bearing housing 123 and a sliding annular vacuum seal may be arranged between the seal carrier 124 and the upper wall 127 of the external housing.

According to embodiments, two annular sliding seals 117, e.g. fluid seals 117, are arranged between the target flange 121 and the base body 110. Using at least one annular sliding fluid seal avoids an exchange of coolant, bearing grease and vacuum lubricants, respectively. Thereby, the bearing system 149 is protected against penetration of coolant. Further, penetration of grease into the cooling system is avoided.

According to embodiments, a current collector plate 122 is mounted to the bearing housing 123 at a lower end of the rotor 120, i.e. opposite to the target flange 121. The current collector plate 122 is typically also of an annular shape in cross-sections which are orthogonal to the rotational axis 50. The current collector plate 122 is typically used to transmit electric current to the rotatable target.

According to embodiments, which can be combined with other embodiments described herein, a combined coolant unit and electrical support unit 130 is arranged below the current collector plate 122. The combined unit 130 is non-rotatable to the base body 110 and includes both a discharge tube 131 and at least one coolant supply tube 132 (see Fig .3) which lead through the base body 110. Further, sliding electrical contacts 135 are arranged on and protrude of, respectively, a main body 133 of the combined unit 130 and in contact with the current collector plate 122. Thereby, the rotational target may be provided with electrical and fluid support.

According to embodiments, an insulating plate 116 which is orientated perpendicular to the rotational axis 50 is fastened, typically with screws 204, to a lower part 119 of the base body 110. Thereby, the inner part of the end-block 100, i.e. the base body 110, is insulated against and non-rotatably mounted to the external housing.

According to embodiments, the insulating plate 116 is fastened, typically screwed, to the lower wall 126 to stabilize the base body 110 in the external housing and to fix the rotational axis 50 relative to the external housing. The insulating plate 116 and the lower wall 126 may be screwed together using additional screws. Alternatively and/or in addition, the shown screws 204 may extend at least partially into the lower wall 126. In this event, the screws 204 are typically insulated against the lower part 119 of the base body 110.

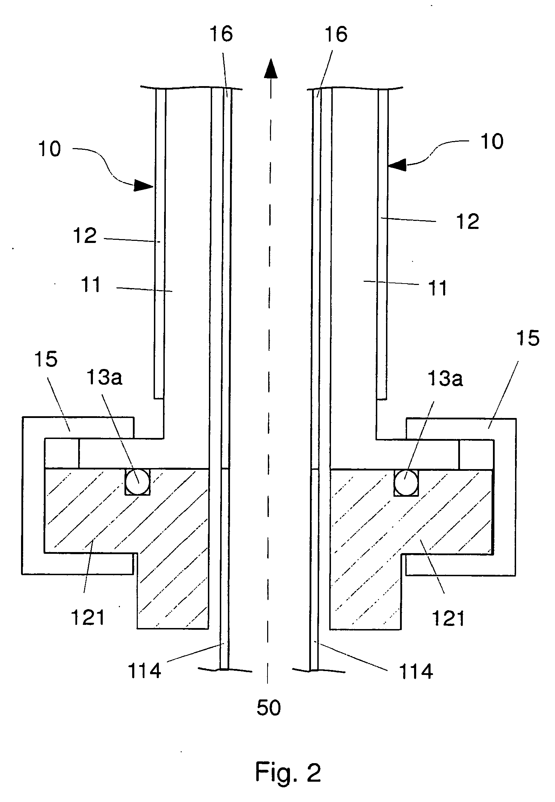

Fig. 2 shows schematically a cross section of a rotatable target 10 mounted to a target flange 121 of an end-block along the rotational axis 50. According to embodiments, the target flange 121 and the rotatable target 10 are coaxial to each other.

The term "rotatable target" as used herein shall embrace any cathode assembly which is adapted to be rotatably mounted to a sputtering installation and which includes a target structure adapted for being sputtered. The term "rotatable target" as used herein shall particularly embrace magnetically enhanced cathode assemblies which in addition include internal magnetic means, e.g. permanent magnets, for improved sputtering.

Typically, the rotatable target 10 includes a backing tube 11 and a target tube 12 disposed on the backing tube 11. The term "target tube" as used herein shall embrace any shell, in particular formed as a hollow cylinder, of material suitable to be sputtered.

Support of the target tube may include mechanical support, providing electrical contact and providing cooling of the target tube and the optional magnets.

Alternatively, the rotatable target may also be a monolithic target. In this case, the shape of the rotatable target may be similar to the shape of the rotatable target 10 shown in Fig. 2. The shown adjoining regions 11 and 12 typically form, in this case, a simply-connected region of the same material.

Support of the rotatable target may include at least one of mechanical support, providing electrical contact and providing cooling of the target tube and the optional magnets.

Typically, the rotatable target 10 is fitted to an upper part of the target flange 121 using an annular clamp 15 which presses the rotatable target 10 to the target flange 121. An O-ring seal 13a is typically arranged between the target flange 121 and an adjoining part of the backing tube 11 and the rotatable target 10, respectively. Accordingly, the rotatable target 10 is vacuum-tightly mounted to the target flange 121.

According to embodiments, the rotatable target 10 is vacuum-tightly mounted to the upper part of the target flange 121. This is typically achieved by an annular sealing (not shown). Thereby, fluid leakage to the low pressure process chamber is prevented.

According to embodiments, the rotatable target 10 includes a tubular internal structure 16 that is liquid-tightly mounted to a coolant tube 114 of the end-block for cooling the rotatable target 10, in particular optional magnets (not shown) provided inside the rotatable target 10.

In order to operate the rotatable target 10 as a cathode during sputtering, at least one electric supply (not shown) for the rotatable target 10 is typically also provided through the target flange 121.

According to embodiments, which may be combined with other embodiments disclosed herein, the target flange is adapted to mechanically support the rotatable target. In addition, coolant and electric supply for the target tube may be provided through the target flange.

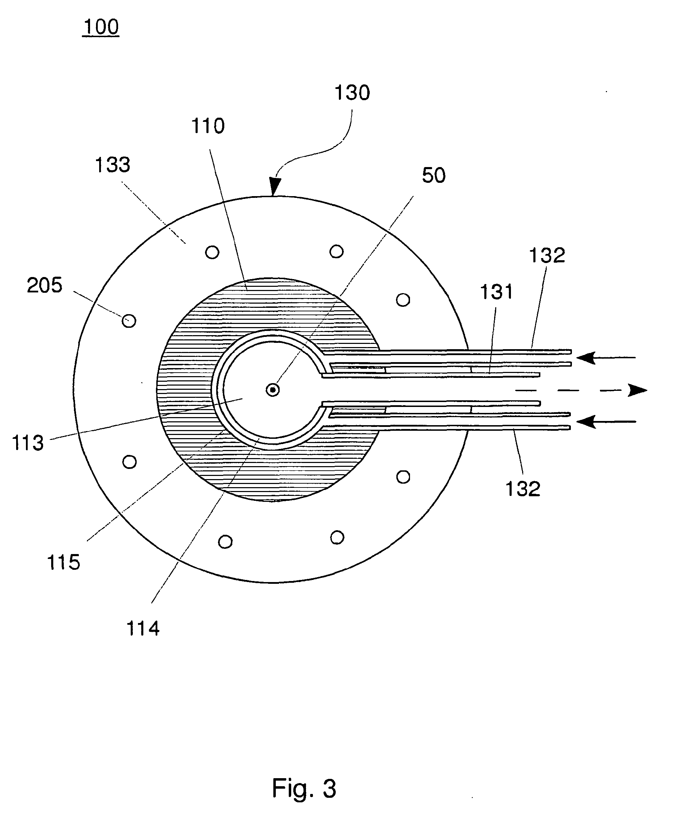

Fig. 3 shows schematically a cross section of the end-block 100 along the line A-A' of Fig. 1. According to embodiments, the end-block 100 includes a coolant supply and discharge unit 130 which is arranged between the current collector plate and the insulating plate. The cross section of Fig. 3 corresponds to a section through the coolant supply and discharge unit 130.

Typically, the coolant supply and discharge unit 130 includes a discharge tube 131 and two coolant supply tubes 132 which are fed through the base body 110 and a main body 133 of the unit 130 in a plane essentially perpendicular to the axis 50. The discharge tube 131 leads into an opening of the coolant tube 114 and the coolant supply tubes 132 lead into the annular coolant interspace 115 formed between the base body 110 and coolant tube 114. As indicated by the full arrows, a coolant may be provided to the supply tubes 132. During sputtering, the coolant typically flows through the supply tubes 132 and upwards in the coolant interspace 115 to the rotatable target. The backflow of the warmed-up coolant typically goes downwards through the coolant tube 114 and is discharged in radial direction through the discharge tube 131, as indicated by the dashed arrow. Thereby, a closed coolant circuit may be provided for the rotatable target. The flow direction in the closed coolant circuit may also be reversed.

Typically, the coolant supply and discharge unit 130 includes in a radially outward part through holes for fastening, typically screwing, the coolant supply and discharge unit 130 to the lower part 119 of the base body 110.

On top of the coolant supply and discharge unit 130 sliding electric contacts are provided. The sliding electric contacts are arranged above the cross section of Fig. 3 and are therefore not shown. For clarity reasons the support structure for the sliding contacts are also not shown. The sliding electric contacts and their support structure typically form an electrical support unit.

According to embodiments, which may be combined with other embodiments disclosed herein, the end-block includes a coolant supply and discharge unit and/ or an electrical support unit which are arranged between the current collector plate and the insulating plate. The end-block may e.g. include a combined unit integrating the functions of the electrical support unit and the coolant supply and discharge unit.

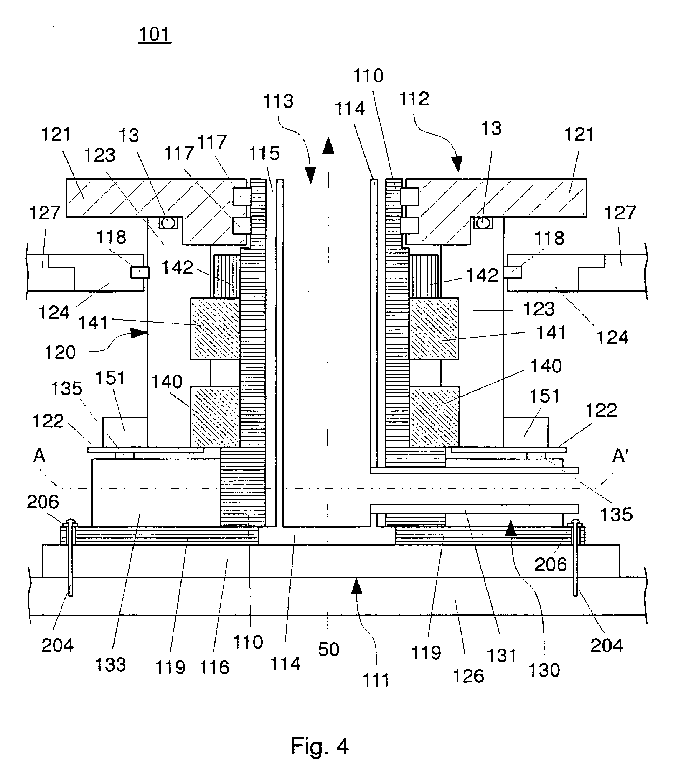

Fig. 4 shows schematically a cross section of an end-block along the rotational axis 50 according to embodiments. The end-block 101 of Fig. 4 is similar to the end-block 100 of Fig. 1. Most of the elements in Fig. 4 are similar to the corresponding elements in Fig. 1. For sake of clarity, these elements are referred to with the same respective reference numbers.

According to embodiments, the end-block 101 includes a base body 110 which is adapted to be rigidly coupled to a non-revolving part of a sputtering installation. The end-block 101 further includes a rotor 120 which is rotatably mounted around the base body 110 and adapted to receive the rotatable target. Accordingly, the rotatable target may be fastened to a target flange 121 of the end-block 101 as explained with reference to Fig. 2 for the target flange of the end-block of Fig. 1.

Typically, the end-block 101 also rotatably transfers movement, coolant and electrical current to the rotatable target while maintaining vacuum integrity and a closed coolant circuit. Accordingly, Fig. 3 may also correspond to a cross section along the line AA' in Fig. 4.

According to embodiments, the end-block 101 includes two annular rotary bearings 140 and 141 which are arranged between the base body 110 and the rotor 120 and spaced apart from each other in axial direction. Using two rotary bearings 140 and 141 allows for a particularly compact and comparatively lightweight design of the bearing system. Typically, at least one of the two rotary bearings 140 and 141 is adapted to carry both radial and axial loads.

According to embodiments, an annular slotted round nut 142 is arranged between the base body 110 and the rotor 120. The annular slotted round nut 142 typically presses the rotary bearing 141 and, therefore, braces the rotor 120 relative to the base body 110. This allows for a stable bearing of the typically long rotatable target.

According to embodiments, the screws 204 are insulated against the lower part 119 of the base body 110 by respective insulating washers 206. Accordingly, the screws 204 may extend into the lower wall 126 without electrically connecting the lower wall 126 of the external housing with the base body 110.

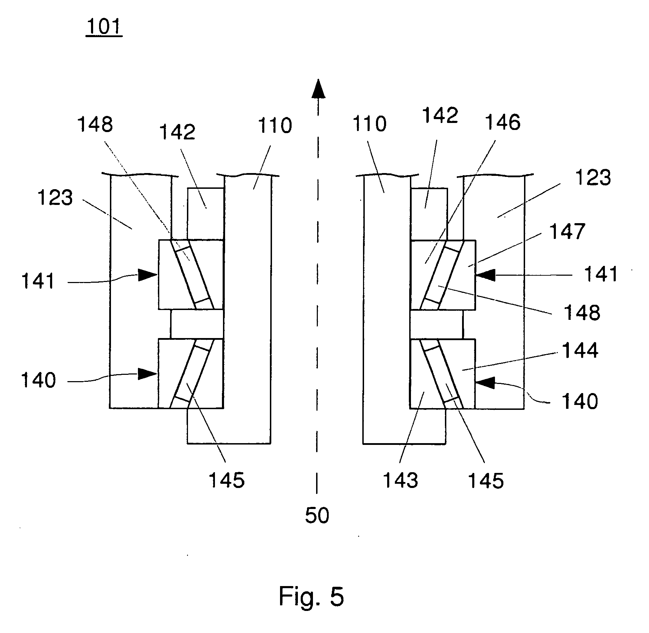

Fig. 5 shows schematically a section of the cross section of Fig. 4 according to embodiments. Each of the two rotary bearings 140 and 141 include an inner ring 143 and 146, respectively, an outer ring 144 and 147, respectively, and a conical roller 145 and 148, respectively, running on the conical races. In other words, the rotary bearings 140 and 141 are, according to embodiments, annular tapered roller bearing. Due to their design, the tapered roller bearings 140 and 141 support both radial and axial loads.

According to embodiments, the inclination of the conical roller 145 and 148 is opposite relative to the rotational axis 50 but typically of same absolute value. Thereby, the bearing system can equally well carry both positive and negative axial loads.

The inner rings 143 and 146 are fastened to the base body 110 and the outer ring 144 and 147 are fastened to the bearing housing 132. In other words, the bearings 140 and 141 are arranged around the base body 110 and the rotor 120 is arranged around the bearings 140 and 141.

According to embodiments, an annular slotted round nut 142 presses the rotary bearing 141. Thereby, the rotary bearing 141 is pre-stressed. In addition, this also results in pre-stressing of the rotary bearing 140 via the bearing housing 132. This allows for a stable bearing of a typically long rotatable target.

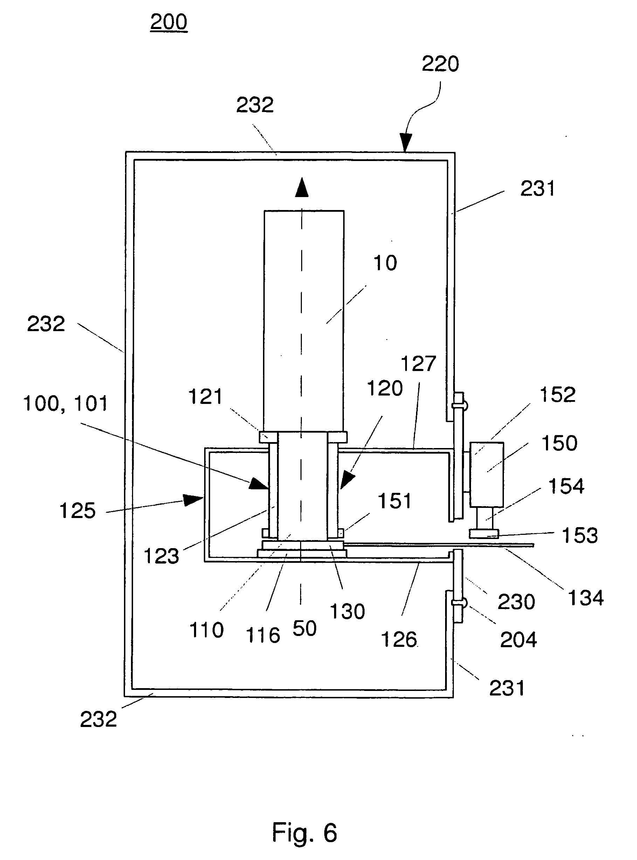

Fig. 6 shows schematically a cross section of a sputtering installation 200 along the rotational axis 50 according to embodiments. The sputtering installation 200 typically includes a process chamber 220 formed by walls 231 and 232. Thereby, according to typical embodiments, the axis 50 of the cathode, the target, the backing tube or the bearing is essentially parallel to the wall 231 the end-block 100, 101is attached to. Thereby, a drop-in configuration of the cathode is realized.

According to embodiments, at least one end-block 100 or 101, as explained with reference to the previous Figures, is mounted into the process chamber 220 such that the base body 110 of the end-block 100, 101 is not rotatably relative to the walls 231 of the process chamber 220. The base body 110 is typically fastened via an insulating plate 116 and to a flap or door 230 of the process chamber 220. During sputtering, the flap or door 230 is closed. Accordingly, the base body 110 is typically stationary, at least non-rotatable, during sputtering. Alternatively, the external housing 125 may be fastened directly to a wall 231 of the process chamber 220.

According to embodiments, a rotating drive 150, typically an electrical drive is arranged outside the process chamber 220 via a mounting support 152. The rotating drive 150 may, however also be placed within the external housing 125. Typically, the rotating drive 150 drives the rotatable target 10 during sputtering via its motor axis 154, a pinion 153 connected thereto and a chain or a toothed belt (not shown) which loops around the pinion 153 and a gear-wheel 151 attached to a bearing housing 123 of the rotor 120.

Typically, coolant support tubes 134 and/or electrical support lines 134 are fed from the coolant supply and discharge unit 130 and/or an electrical support unit 130 through the external housing 125 to the outside of the process chamber 220.

The rotatable target 10 is typically supported by the end-block 100, 101 in a cantilevered arrangement above a substrate (not shown). In addition, the rotatable target 10 may be further supported at its upper end.

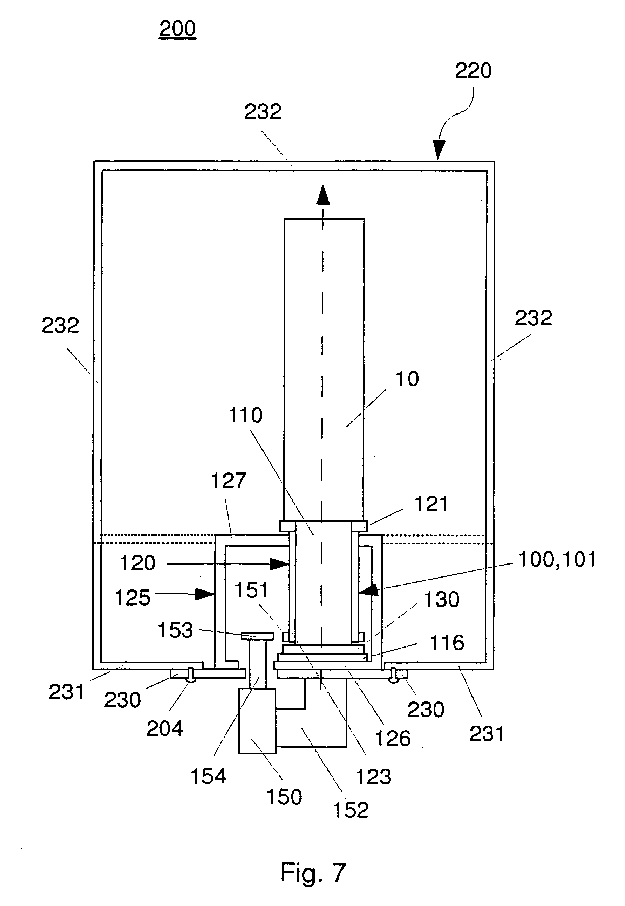

Fig. 7 shows schematically a cross section of a sputtering installation 200 according to embodiments. Thereby, according to typical embodiments, the axis 50 of the cathode, the target, the backing tube or the bearing is essentially perpendicular to the flange 230 connecting the end-block 100, 101 to the processing chamber 220. The sputtering installation 200 of Fig. 7 is similar to the sputtering installation of Fig. 6. However, the insulating plate 116 in Fig. 7 is orientated parallel to the wall 231 and flap 230, respectively, to which the end-block 100, 101 is mounted. Different thereto, the insulating plate 116 in Fig. 6 is orientated perpendicular to the wall 231 and flap 230, respectively, to which the end-block 100, 101 is mounted. Further, the motor axis 154 extends into the external housing 125 in the embodiment of Fig. 7. For sake of clarity, coolant support tubes and electrical support lines, which are typically also used in the embodiment of Fig. 7, are not shown.

According to embodiments, the lower wall 126 of the external housing 125 is mounted to the wall 231 or to the door 230 and flap 230, respectively, as shown in Fig. 7.

According to other embodiments, the end-block 100, 101 is mounted to the wall 231 such that the wall 231 of the vacuum chamber 220 and the upper wall 127 of the external housing 125 form an essentially flat transition region inside the vacuum chamber 220 or a transition region having a small step only. This is indicated by the dotted horizontal lines in Fig. 7. In these embodiments, the internal volume of the vacuum chamber 220 may be reduced. The arrangement of Fig. 7 is typically used for sputtering installations in which the substrate is orientated horizontally with respect to gravity. The arrangement of Fig. 6 may be used for horizontally and vertically orientated substrates.

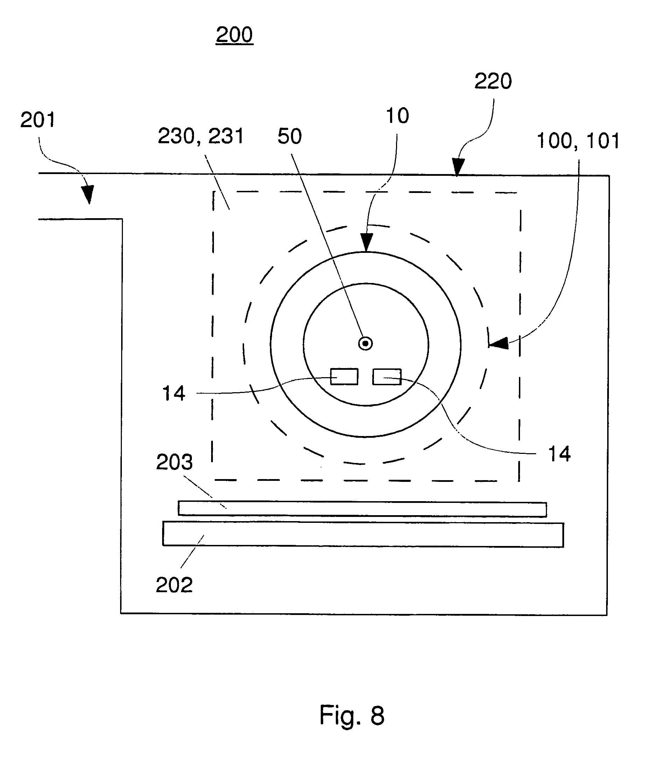

Fig. 8 illustrates a sputtering installation 200 as shown in Fig. 6 and 7. The schematic cross-section of Fig. 8 is orthogonal to the cross-section of Fig. 6 and 7, respectively. According to an embodiment, the sputtering installation 200 has a vacuum chamber 220 including a gas inlet 201 for providing processing gas, for example argon, to the vacuum chamber 220. The vacuum chamber 220 further includes a substrate support 202 and a substrate 203 arranged on the substrate support 202. Further, the vacuum chamber 220 includes a rotatable target 10, typically in a cantilevered arrangement above the substrate 203.

Typically, a high voltage difference is applied between the rotatable target 10 operating as a cathode and the substrate support 202 operating as an anode. The plasma is typically formed by impact ionization of accelerated electrons with e.g. Argon atoms. The formed Argon ions are accelerated in direction of rotatable target 10 such that particles, typically atoms, of the rotatable target 10 are sputtered and subsequently deposited on the substrate 203.

In embodiments, other suitable gases, e.g. other inert gases such as krypton or a reactive gas such as oxygen or nitrogen may be used to create the plasma. According to typical embodiments, which can be combined with other embodiments described herein, the pressure in the plasma area can be about 10⁻⁴ mbar to about 10⁻² mbar, typically about 10⁻³ mbar. In a further embodiment, the vacuum chamber 220 may include one or more openings and/or valves for introducing or retracting the substrate 203 in or out of the vacuum chamber 220.

Magnetron sputtering is particularly advantageous in that its deposition rates are rather high. By arranging one or more magnets 14 inside the rotatable target 10, free electrons within the generated magnetic field directly below the target surface may be trapped. This enhances the probability of ionizing the gas molecules typically by several orders of magnitude. In turn, the deposition rate may be increased significantly. Depending on the application and the material to be sputtered, stationary or time varying magnetic fields may be used. Furthermore, a cooling fluid is typically circulating within rotatable target 10 for cooling the magnets 224 and/ or the target 10.

The rotatable target 100 is typically supported by a cathode drive-block 100, 101 which is not visible in the shown cross-section and therefore drawn as a dashed circle.

Typically, the cathode drive-block 100, 101 is non-rotatably mounted to a wall 230 or door 231 or flap 231 of the process chamber 220 which is not visible in the shown cross-section and therefore drawn as a rectangle.

The cathode drive-block typically includes a base body which is adapted to be rigidly coupled to a non-revolving part such as a wall, door or flap of the sputtering installation.

According to embodiments, which may be combined with other embodiments disclosed herein, the sputtering installation includes a process chamber having a wall to which the cathode drive-block is attached such that the rotational axis of the cathode, the target, the backing tube or the bearing is parallel to the wall, i.e. with an angular accuracy of at least 5°.

According to embodiments, which may be combined with other embodiments disclosed herein, a rotor, which is adapted to receive the rotatable target, is rotatably mounted around the base body.

According to embodiments, which may be combined with other embodiments disclosed herein, a bearing system is arranged between the base body and the rotor. The bearing system is typically adapted to carry radial and axial loads.

According to embodiments, which may be combined with other embodiments disclosed herein, the bearing system includes at least one rotary bearing.

According to embodiments, which may be combined with other embodiments disclosed herein, the bearing system includes two annular tapered roller bearings which are spaced apart from each other in direction of the rotational axis and arranged between the base body and the rotor.

According to embodiments, which may be combined with other embodiments disclosed herein, the bearing system further includes an annular slotted round nut arranged between the base body and the rotor. The annular slotted round nut typically braces the two annular tapered roller bearings against one another.

According to embodiments, which may be combined with other embodiments disclosed herein, the rotor includes at an upper end a target flange which is adapted to mechanically support the rotatable target.

According to embodiments, which may be combined with other embodiments disclosed herein, the rotor further includes a bearing housing which is vacuum-tightly attached to the target flange.

According to embodiments, which may be combined with other embodiments disclosed herein, the cathode drive-block includes a rotating drive which is mechanically connected to the bearing housing.

Even though each of the Figs. 6 to 8 shows only one rotatable target, according to different embodiments, which may be combined with other embodiments disclosed herein, two or more rotatable targets may be supported by respective cathode drive-blocks and disposed in the vacuum chamber. Typically, the cylindrical axes of the two or more rotatable targets are substantially parallel, i.e. parallel within an angular accuracy of at least 5°, more typically within an angular accuracy of at least 1°.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. An end-block (100, 101) for carrying a rotatable target (10) of a deposition apparatus (200), comprising:
- a base body (110) adapted to be rigidly connected to a non-revolving part (230, 231) of the deposition apparatus (200), the base body (110) comprising a cylindrical cavity (113);
- a coolant tube (114);
- at least one rotary bearing (140, 141) arranged around the base body (110) and defining a rotational axis (50); and
- a rotor (120) adapted to receive the rotatable target (10) and arranged around the at least one rotary bearing (140, 141),
wherein the cylindrical cavity (113) is arranged coaxially to the rotational axis (50), **characterized in that** the coolant tube (114) is coaxially inserted into the cylindrical cavity (113).

2. The end-block (100, 101) of claim 1, wherein the at least one rotary bearing (140, 141) is an annular tapered roller bearing (140, 141).

3. The end-block (100, 101) of claim 1 or 2, wherein the at least one rotary bearing (140, 141) is a pre-stressed bearing (140, 141).

4. The end-block (100, 101) of any of the preceding claims, comprising two annular tapered roller bearings (140, 141) which are spaced apart from each other in direction of the rotational axis (50) and arranged between the base body (110) and the rotor (120).

5. The end-block (100, 101) of claim 4, further comprising an annular slotted round nut (142) arranged between the base body (110) and the rotor (120) and bracing the two annular tapered roller bearings (140,141) against one another.

6. The end-block (100, 101) of any of the preceding claims, wherein the rotor (120) comprises, in direction of the rotational axis (50), at an upper end (112) a target flange (121) adapted to mechanically support the rotatable target (10).

7. The end-block (100, 101) of any of the preceding claims, further comprising, in direction of the rotational axis (50), at a lower end (111) an insulating plate (116) which is orientated perpendicular to the rotational axis (50) and fastened to the base body (110).

8. The end-block (100, 10 1) of claim 7, wherein the rotor (120) comprises a current collector plate (122) which is arranged, in direction of the rotational axis (50), opposite to the target flange (121).

9. The end-block (100, 101) of claim 8, further comprising between the current collector plate (122) and the insulating plate (116) a coolant supply and discharge unit (130).

10. The end-block (100, 101) of claim 8 or 9, further comprising between the current collector plate (122) and the insulating plate (116) an electrical support unit (130).

11. The end-block (100, 101) of any of the claims 6 to 10, further comprising at least one annular sliding fluid seal (117) arranged between the target flange (121) and the base body (110).

12. The end-block (100, 101) of any of the claims 6 to 11, further comprising a rotating drive (150), wherein the rotor (120) further comprises a bearing housing (123) vacuum-tightly attached to the target flange (121) and mechanically connected to the rotating drive (150).

13. The end-block (100, 101) of any of the claims 7 to 12, further comprising an external housing (125) fastened to the insulating plate (116) and adapted to be fastened to the non-revolving part (230, 231) of the deposition apparatus (200).

14. A deposition apparatus (200), comprising:
- a process chamber (220) comprising a non-revolving part (230, 231); and
- at least one end-block (100, 101) of any of the preceding claims mounted to the non-revolving part (230, 231).

15. The deposition apparatus of claim 14, wherein the process chamber (220) comprises a wall (231) to which the at least one end-block (100, 101) is attached such that the rotational axis (50) is parallel to the wall (231).

## Patentansprüche

1. Endblock (100, 101) zum Tragen eines drehbeweglichen Targets (10) einer Abscheidungsvorrichtung (200), Folgendes aufweisend:
- einen Grundkörper (110), der angepasst ist, starr mit einem nicht umlaufenden Teil (230, 231) der Abscheidungsvorrichtung (200) verbunden zu sein, wobei der Grundkörper (110) einen zylindrischen Hohlraum (113) aufweist;
- ein Kühlmittelrohr (114);
- mindestens ein Drehlager (140, 141), das um den Grundkörper (110) herum angeordnet ist und eine Drehachse (50) definiert; und
- einen Läufer (120), der angepasst ist, das drehbewegliche Target (10) aufzunehmen und der um das mindestens eine Drehlager (140, 141) herum angeordnet ist,
wobei der zylindrische Hohlraum (113) koaxial zur Drehachse (50) angeordnet ist, **dadurch gekennzeichnet, dass** das Kühlmittelrohr (114) koaxial in den zylindrischen Hohlraum (113) eingesetzt ist.

2. Endblock (100, 101) nach Anspruch 1, wobei es sich bei dem mindestens einen Drehlager (140, 141) um ein ringförmiges Kegelrollenlager (140, 141) handelt.

3. Endblock (100, 101) nach Anspruch 1 oder 2, wobei es sich bei dem mindestens einen Drehlager (140, 141) um ein vorgespanntes Lager (140, 141) handelt.

4. Endblock (100, 101) nach einem der vorhergehenden Ansprüche, umfassend zwei ringförmige Kegelrollenlager (140, 141), die in der Richtung der Drehachse (50) voneinander beabstandet und zwischen dem Grundkörper (110) und dem Läufer (120) angeordnet sind.

5. Endblock (100, 101) nach Anspruch 4, darüber hinaus eine ringförmige, mit Schlitz versehene Rundmutter (142) aufweisend, die zwischen dem Grundkörper (110) und dem Läufer (120) angeordnet ist und die zwei ringförmigen Kegelrollenlager (140, 141) gegeneinander verspannt.

6. Endblock (100, 101) nach einem der vorhergehenden Ansprüche, wobei der Läufer (120) in der Richtung der Drehachse (50) an einem oberen Ende (112) einen Target-Flansch (121) aufweist, der dazu angepasst ist, das drehbewegliche Target (10) mechanisch abzustützen.

7. Endblock (100, 101) nach einem der vorhergehenden Ansprüche, darüber hinaus in der Richtung der Drehachse (50) an einem unteren Ende (111) eine Isolierplatte (116) aufweisend, die senkrecht zur Drehachse (50) ausgerichtet und am Grundkörper (110) angebracht ist.

8. Endblock (100, 101) nach Anspruch 7, wobei der Läufer (120) eine Stromkollektorplatte (122) aufweist, die in der Richtung der Drehachse (50) zu dem Target-Flansch (121) entgegengesetzt angeordnet ist.

9. Endblock (100, 101) nach Anspruch 8, darüber hinaus zwischen der Stromkollektorplatte (122) und der Isolierplatte (116) eine Kühlmittelzuleitungs- und Kühlmittelableitungseinheit (130) aufweisend.

10. Endblock (100, 101) nach Anspruch 8 oder 9, darüber hinaus zwischen der Stromkollektorplatte (122) und der Isolierplatte (116) eine elektrische Versorgungseinheit (130) aufweisend.

11. Endblock (100, 101) nach einem der Ansprüche 6 bis 10, darüber hinaus mindestens eine ringförmige Fluidgleitdichtung (117) aufweisend, die zwischen dem Target-Flansch (121) und dem Grundkörper (110) angeordnet ist.

12. Endblock (100, 101) nach einem der Ansprüche 6 bis 11, darüber hinaus einen drehenden Antrieb (150) aufweisend, wobei der Läufer (120) darüber hinaus ein Lagergehäuse (123) aufweist, das vakuumdicht am Target-Flansch (121) angebracht und mechanisch mit dem drehenden Antrieb (150) verbunden ist.

13. Endblock (100, 101) nach einem der Ansprüche 7 bis 12, darüber hinaus ein äußeres Gehäuse (125) aufweisend, das an der Isolierplatte (116) befestigt und angepasst ist, am nicht umlaufenden Teil (230, 231) der Abscheidungsvorrichtung (200) befestigt zu sein.

14. Abscheidungsvorrichtung (200), Folgendes aufweisend:
- eine Prozesskammer (220), die ein nicht umlaufendes Teil (230, 231) umfasst; und
- mindestens einen Endblock (100, 101) nach einem der vorhergehenden Ansprüche, der am nicht umlaufenden Teil (230, 231) befestigt ist.

15. Abscheidungsvorrichtung nach Anspruch 14, wobei die Prozesskammer (220) eine Wand (231) aufweist, an welcher der mindestens eine Endblock (100, 101) so angebracht ist, dass die Drehachse (50) parallel zur Wand (231) ist.

## Revendications

1. Bloc terminal (100, 101) destiné à porter une cible orientable (10) d'un appareil de dépôt (200), comprenant :
- un corps de base (110) apte à être connecté rigidement à une partie non tournante (230, 231) de l'appareil de dépôt (200), le corps de base (110) comprenant une cavité cylindrique (113) ;
- un tube de réfrigérant (114) ;
- au moins un palier rotatif (140, 141) disposé autour du corps de base (110) et définissant un axe de rotation (50) ; et
- un rotor (120) apte à recevoir la cible orientable (10) et disposé autour de l'au moins un palier rotatif (140, 141),
où la cavité cylindrique (113) est disposée coaxialement à l'axe de rotation (50),
**caractérisé en ce que** le tube de réfrigérant (114) est coaxialement inséré dans la cavité cylindrique (113).

2. Le bloc terminal (100, 101) de la revendication 1, où l'au moins un palier rotatif (140, 141) est un palier à rouleaux coniques annulaires (140, 141).

3. Le bloc terminal (100, 101) de la revendication 1 ou 2, où l'au moins un palier rotatif (140, 141) est un palier précontraint (140, 141).

4. Le bloc terminal (100, 101) de l'une quelconque des revendications précédentes, comprenant deux paliers à rouleaux coniques annulaires (140, 141) qui sont espacés l'un de l'autre dans le sens de l'axe de rotation (50) et disposés entre le corps de base (110) et le rotor (120).

5. Le bloc terminal (100, 101) de la revendication 4, comprenant en outre une rainure ronde fendue annulaire (142) disposée entre le corps de base (110) et le rotor (120) et calant les deux paliers à rouleaux coniques annulaires (140, 141) l'un contre l'autre.

6. Le bloc terminal (100, 101) de l'une quelconque des revendications précédentes, où le rotor (120) comprend, dans le sens de l'axe de rotation (50), à une extrémité supérieure (112), une bride de cible (121) apte à supporter mécaniquement la cible orientable (10).

7. Le bloc terminal (100, 101) de l'une quelconque des revendications précédentes, comprenant en outre, dans le sens de l'axe de rotation (50), à une extrémité inférieure (111), une plaque isolante (116) qui est orientée perpendiculairement à l'axe de rotation (50) et attachée au corps de base (110).

8. Le bloc terminal (100, 101) de la revendication 7, où le rotor (120) comprend une plaque collectrice de courant (122) qui est disposée, dans le sens de l'axe de rotation (50), à l'opposé de la bride de cible (121).

9. Le bloc terminal (100, 101) de la revendication 8, comprenant en outre, entre la plaque collectrice de courant (122) et la plaque isolante (116), une unité d'arrivée et d'évacuation de réfrigérant (130).

10. Le bloc terminal (100, 101) de la revendication 8 ou 9, comprenant en outre, entre la plaque collectrice de courant (122) et la plaque isolante (116), une unité de support électrique (130).

11. Le bloc terminal (100, 101) de l'une quelconque des revendications 6 à 10, comprenant en outre au moins un joint d'étanchéité coulissant annulaire (117) disposé entre la bride de cible (121) et le corps de base (110).

12. Le bloc terminal (100, 101) de l'une quelconque des revendications 6 à 11, comprenant en outre un entraînement rotatif (150), où le rotor (120) comprend en outre un logement de palier (123) attaché de manière étanche au vide à la bride de cible (121) et raccordé mécaniquement à l'entraînement rotatif (150).

13. Le bloc terminal (100, 101) de l'une quelconque des revendications 7 à 12, comprenant en outre un boîtier externe (125) fixé à la plaque isolante (116) et apte à être fixé à la partie non tournante (230, 231) de l'appareil de dépôt (200).

14. Appareil de dépôt (200), comprenant :
- une chambre de procédé (220) comprenant une partie non tournante (230, 231) ; et
- au moins un bloc terminal (100, 101) de l'une quelconque des revendications précédentes monté sur la partie non tournante (230, 231).

15. L'appareil de dépôt de la revendication 14, où la chambre de procédé (220) comprend une paroi (231) sur laquelle l'au moins un bloc terminal (100, 101) est attaché de telle sorte que l'axe de rotation (50) soit parallèle à la paroi (231).
